# FASCICULE DE BREVET EUROPEEN

(11) **EP 3 548 578 B1**
(45) Date de publication et mention de la délivrance du brevet: **20.01.2021**
(21) Numéro de dépôt: 17808885.2
(22) Date de dépôt: 01.12.2017
(51) Int. Cl.: C09K 5/14, H01L 23/373, C08F 8/14, C08G 77/38, C08F 112/14, C08F 112/32

(54) **POLYMERE POUR INTERFACE THERMIQUE DE FAIBLE RESISTANCE THERMIQUE ET INTERFACE THERMIQUE**
POLYMER FÜR THERMISCHE SCHNITTSTELLE MIT NIEDRIGEM THERMISCHEM WIDERSTAND UND THERMISCHE SCHNITTSTELLE
POLYMER FOR THERMAL INTERFACE WITH LOW THERMAL RESISTANCE AND THERMAL INTERFACE

(30) Priorité: 05.12.2016 FR 1601722
(43) Date de publication de la demande: 09.10.2019
(73) Titulaire: Thales, 92400 Courbevoie (FR)
(72) Inventeur: DAON, Joffrey, 91470 Limours (FR); GALINDO, Christophe, 78851 Elancourt Cedex (FR); LEVEUGLE, Elodie, 92622 Gennevilliers Cedex (FR)
(74) Mandataire: Marks & Clerk France
(86) Numéro de dépôt international: PCT/EP2017/081239
(87) Numéro de publication internationale: WO 2018/104180

(56) Documents cités:
- WO-A1-2012/126955
- WO-A1-2013/096918
- CN-A- 104 356 390
- US-A1- 2012 038 249
- Junxiao Yang ET AL: "Recent Progress in Benzocyclobutene Related Polymers" In: "Polymerization", 12 septembre 2012 (2012-09-12), InTech, XP055422707, ISBN: 978-953-51-0745-3 DOI: 10.5772/48129, alinéa [03.1] alinéa [03.2] Scheme 7, Scheme 10
- DIMITRIOS PRIFTIS ET AL: "Novel diblock copolymer-grafted multiwalled carbon nanotubes via a combination of living and controlled/living surface polymerizations", JOURNAL OF POLYMER SCIENCE, PART A: POLYMER CHEMISTRY, vol. 48, no. 5, 1 mars 2010 (2010-03-01), pages 1104-1112, XP055386682, ISSN: 0887-624X, DOI: 10.1002/pola.23865

## Description

L'invention concerne le domaine des matériaux d'interfaces thermiques pour applications dans les dispositifs électroniques et la microélectronique de puissance.

Dans ce domaine, le nombre de composants par unité de surface a suivi durant des décennies une loi exponentielle : la loi de Moore. La forte tendance à la miniaturisation est à l'origine de l'augmentation de la densité d'énergie à évacuer sous forme de chaleur. En effet, environ 40 % de l'énergie fournie à ces composants électroniques est perdue par effet Joule.

Cette augmentation de densité de chaleur produite rend le contrôle de la température de fonctionnement difficile, ce qui a pour effet de diminuer la fiabilité des systèmes électroniques. C'est pour cette raison que le management thermique est indispensable pour garantir le bon fonctionnement des dispositifs de puissance dans leur environnement et assurer l'adéquation avec les spécifications techniques requises. Dans ce contexte, pour répondre aux besoins de la microélectronique de puissance, l'utilisation de Matériaux d'Interface Thermique (TIMs) représente un point clé dans l'évolution des composants électroniques de puissance. La fonction de ces matériaux est d'améliorer l'évacuation de la chaleur des composants électroniques vers le milieu environnant via un dissipateur thermique (radiateur, fluide caloporteur). Il existe deux types de TIMs commercialisés, les TIMs 1 qui sont intégrés entre la puce et le boitier et les TIMs 2 présents entre le boitier et le dissipateur thermique.

Aujourd'hui, plusieurs catégories de TIMs à base de polymère de silicone chargé de particules métalliques existent (e.g. graisses thermiques, adhésifs thermiques, pâtes thermiques). Néanmoins, ces TIMs ne possèdent qu'une conductivité thermique intrinsèque faible allant de 2 à 8 W/m.K. Ces performances limitent fortement le fonctionnement des dispositifs dès lors qu'une augmentation de la densité de chaleur à évacuer est envisagée. Il existe également des TIMs à base de soudures ayant une conductivité thermique comprise entre 50 à 100 W/m.K, mais ces derniers présentent l'inconvénient de posséder un faible coefficient d'adaptation thermique (CTE) qui représente également un point essentiel à prendre en compte pour l'élaboration d'un TIM. Ces TIMs commerciaux ne permettent donc pas de répondre à l'ensemble des besoins futurs de la microélectronique de puissance (Tableau 1).

| Type de TIM | Conductivité thermique (W/m.K) | Résistance thermique (mm²K/W) pour e=10µm | Avantages | Inconvénients |
|---|---|---|---|---|
| Graisses et Gels thermiques | 0,5-4 | 2,5-20 | - Conductivité thermique peut être élevée | - Ecoulement sous sollicitations mécaniques |
| | | | - Dépôt de faible épaisseur possible | |
| | | | - Pas de délamination des TIMs | |
| | | | - Pas d'étape de recuit | |
| Elastomères | 0,9-2,5 | 4-11 | - Facile à manipuler | Faible |
| | | | - Contrôle de la quantité de dépôt | - conductivité thermique |
| | | | - Capacité à se conformer à la surface | - Etape de recuit nécessaire |
| | | | - Pas de migration | - Délamination des TIMs possible |
| | | | - Résistant à l'environnement | |
| | | | - Bonne propriété électrique | - Coût élevé |
| Adhésifs | 0,8-1,5 | 6,7-12,5 | - Capacité à se conformer à la rugosité de surface avant recuit | - Faible conductivité thermique |
| | | | | - Etape de recuit nécessaire |
| | | | | - Délamination possible |
| | | | - Pas de migration | - Problème d'adaptabilité des CTE |
| Soudures | 30-50 | 0,2-0,3 | - Excellente conductivité thermique | - Formations d'intermétalliques diminuant la conductance thermique |
| | | | | - Absence d'adaptabilité des CTE et délamination possible |
| | | | | - Température de soudure élevée |
| Matériaux à changement de phase | 0,9-1,6 | 6,25-11 | - Grande viscosité | |
| | | | - Application aisée par | - Faible conductivité thermique |
| | | | rapport aux graisses | - Application d'une pression nécessaire lors de la fermeture d'interface induisant un stress mécanique |
| | | | - Pas d'étape de recuit | |
| | | | - Pas de délamination possible des TIMs | |

Afin d'améliorer l'évacuation de la chaleur, différentes études rapportées, issues de plusieurs groupes de recherches, ont démontré que l'utilisation de tapis de nanotubes de carbone verticalement alignés (VACNTs) associée à celle d'un polymère spécifique peut conduire à une conductivité thermique intrinsèque du TIM allant jusqu'à 20W/m.K.

WO 2013/096918 A1 décrit des polymères à base de triscarbazole pouvant comprendre des unités dérivées d'un monomère comportant un groupement benzocyclobutane.

Le Demandeur a précédemment déposé une demande de brevet publiée sous le numéro WO 2012/126955 A1. Cette demande de brevet mentionne l'état de l'art justifiant de l'utilisation d'un polymère en tant que matériau de fermeture d'interface thermique. De plus, lorsque le polymère possède des fonctions organiques capables de réagir sur les nanotubes de carbone et de créer des liaisons covalentes avec ces derniers, cela permet de diminuer la résistance de contact et la résistance thermique des interfaces.

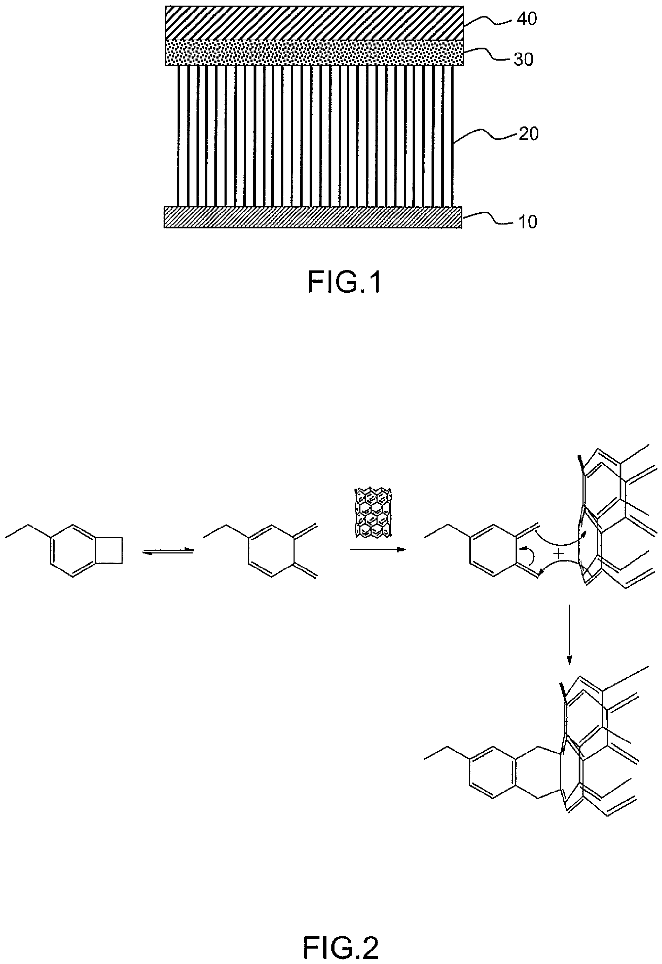

Le matériau d'interface est donc réalisé à partir d'un substrat de silicium sur lequel les VACNTs ont cru. Une couche de polymère est déposée sur un substrat de cuivre par spin-coating ou spray- coating. Ce dernier substrat est déposé (face polymère vers les VACNTs) sur le haut des VACNTs comme illustré en figure 1. Plus précisément un substrat de silicium 10 supporte des VACNTs 20 en contact avec un film de polymère 30 déposé à la surface d'un substrat 40 pouvant être en cuivre.

Les nanotubes de carbone ont pour rôle d'être de très bons conducteurs thermiques et de s'adapter aux différences de CTE.

Le polymère sert d'adhésif entre les nanotubes de carbone et le substrat opposé. De plus, il est capable de réaliser des liaisons covalentes avec les nanotubes de carbone. Ces liaisons covalentes ont pour intérêt d'optimiser le transfert phononique entre les nanotubes de carbone et le polymère. La résistance thermique de contact est donc diminuée.

L'état de l'art des matériaux d'interface thermique montre que les meilleurs résultats répertoriés sont ceux obtenus par la méthode décrite dans le brevet WO 2012/126955 A1. Cette méthode fait intervenir un polymère possédant des fonctions organiques « azotures », capable d'engendrer des liaisons covalentes avec les nanotubes de carbone dont la formule chimique est la suivante : 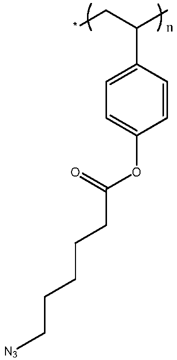 avec n ≥ 1

L'efficacité de ce matériau d'interface thermique a été caractérisée thermiquement et démontre de bonnes performances thermiques (résistance thermique de l'ordre de 1-5 / 2 mm²K/W) pour des températures de mise en œuvre inférieures à 120°C.

Cependant, des spécifications techniques de mise en œuvre des composants et opérations de packaging nécessitent des étapes de recuits pouvant aller jusqu'à 230 / 250°C durant plusieurs heures.

Les interfaces réalisées avec les polymères décrits dans la demande de brevet WO 2012/126955 A1 génèrent des résistances thermiques de 3-4 mm²K/W après un passage en étuve à 250°C pour des épaisseurs de VACNTs de 10 µm. Ces valeurs représentent une augmentation de plus de 200% de la résistance thermique des interfaces.

Le Demandeur a cherché à comprendre l'origine de cette augmentation de la résistance thermique lorsque la température de recuit augmente, l'objectif recherché étant de retrouver des résultats de l'ordre du mm²K/W.

Le Demandeur a mené des études pour comprendre la différence de résistance thermique obtenue lorsque la température de recuit passe de 120°C à 250°C.

Il a été conclu qu'il y avait apparition de zones interstitielles remplies de diazote provenant de la réactivité du polymère lorsque ce dernier est chauffé au-delà des 200°C.

La présence de ces zones interstitielles remplies de diazote a pour effet :
- d'augmenter d'un facteur 2 l'épaisseur de la couche de polymère. Le Demandeur a montré, par une étude de l'influence de l'épaisseur de la couche de polymère, que pour atteindre une résistance thermique minimale, il existe une épaisseur optimale à déposer. Cette épaisseur est de 300 à 400 nm. Lorsque l'épaisseur dépasse ces valeurs alors la résistance thermique de l'interface augmente ;
- de créer des zones de constriction du flux thermique, ce qui participe à l'augmentation de la résistance thermique de la couche de polymère et donc de l'interface finale.

Dans ce contexte, le Demandeur a élaboré une nouvelle famille de polymère comportant un groupement benzocyclobutane, permettant d'améliorer les performances thermiques des interfaces et permettant de remédier au problème de libération de diazote.

Plus précisément la présente invention a pour objet un polymère apte à créer des liaisons avec un nanomatériau présentant des motifs insaturés capables de réagir par cycloaddition avec le benzocyclobutane caractérisé en ce que le polymère étant un homopolymère ou un copolymère, il comprend au moins un groupement benzocyclobutane en chaîne principale ou en chaîne pendante et répond à l'une des formules chimiques suivantes : 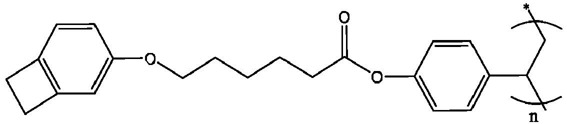 avec n ≥ 1
ou 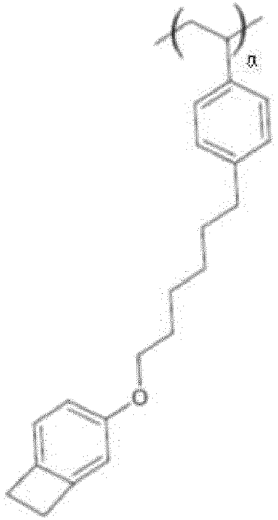 avec n ≥ 1
ou 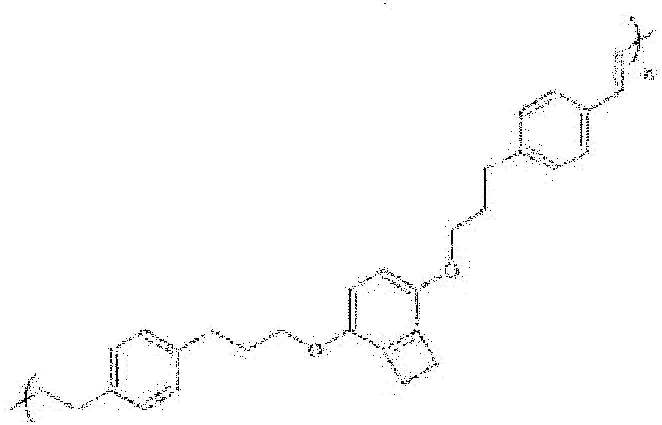 avec n ≥ 1
ou 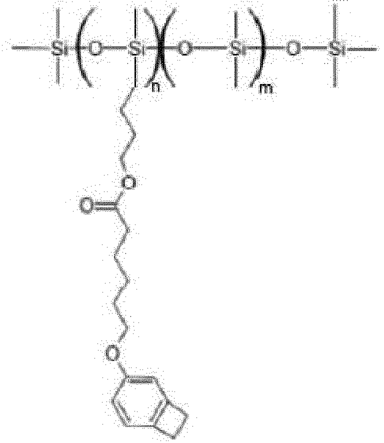 avec n ≥ 1 et avec m ≥ 1

On définit un motif insaturé comme un motif présentant des liaisons chimiques qui ne sont pas simples, par exemple double ou triple.

Le nanomatériau peut comprendre des éléments C et/ou B et/ou N, pouvant être de type nanotubes de carbone, nanotubes de BN, ou des nanotubes de carbone dopés N ou encore des feuillets de graphène pouvant être dopés N, des nanofibres de carbone.

L'invention a aussi pour objet un procédé de synthèse d'un polymère selon l'invention, comprenant les étapes suivantes :
- le greffage d'un composé comprenant un groupement benzocyclobutane avec un groupement espaceur pour obtenir un composé intermédiaire ;
- le greffage dudit composé intermédiaire sur un polymère hôte.

Selon des variantes de l'invention, le polymère hôte est du poly(4-vinylphénol).

L'invention a aussi pour objet une interface thermique comprenant au moins une couche de nanomatériau présentant des motifs insaturés capables de réagir par cycloaddition avec le benzocyclobutane, caractérisée en ce qu'elle comporte en outre au moins une couche de matériau polymère selon l'invention, en contact avec ladite couche de nanomatériau.

Selon des variantes de l'invention, l'interface comporte une couche de nanomatériau présentant des motifs insaturés capables de réagir par cycloaddition avec le benzocyclobutane, comprise entre une première couche de polymère selon l'invention et une seconde couche de polymère selon l'invention.

L'interface de la présente invention peut comprendre au moins une couche de nanomatériau comprenant des éléments C et/ou B et/ou N, pouvant être de type nanotubes de carbone, nanotubes de BN, ou des nanotubes de carbone dopés N ou encore des feuillets de graphène pouvant être dopés N, des nanofibres de carbone, et au moins une couche de polymère selon l'invention.

L'invention a encore pour objet un dispositif électronique comprenant une interface thermique selon l'invention insérée entre un premier substrat et un second substrat, le premier substrat étant un substrat dissipant thermiquement et le second substrat étant un substrat dissipateur thermiquement.

L'invention a également pour objet un procédé de fabrication d'une interface thermique selon l'invention, caractérisé en ce qu'il comprend les étapes suivantes :
- la réalisation d'une couche de nanomatériau présentant des motifs insaturés capables de réagir par cycloaddition avec le benzocyclobutane à la surface d'un premier support de croissance ;
- la réalisation d'une couche de polymère selon l'invention à la surface d'un second support ;
- l'assemblage des deux supports.

Selon des variantes de l'invention, le procédé comprend :
- la réalisation d'une couche de nanomatériau présentant des motifs insaturés capables de réagir par cycloaddition avec le benzocyclobutane à la surface d'un premier support de croissance ;
- la réalisation d'une couche de polymère selon l'invention à la surface d'un second support ;
- l'assemblage des premier et second supports ;
- une opération de retrait dudit premier support après assemblage, de manière à le désolidariser de la couche de nanomatériau ;
- le report d'un troisième support sur lequel est déposé une seconde couche de polymère selon l'invention à la surface de la couche de nanomatériau.

Selon des variantes de l'invention, le procédé de fabrication de l' interface thermique comporte au moins un assemblage réalisé en appliquant une pression pouvant être de quelques centaines de kPa.

Selon des variantes de l'invention, le procédé de fabrication de l' interface thermique comporte au moins une étape de recuit d'au moins un assemblage préconstitué.

L'invention sera mieux comprise et d'autres avantages apparaîtront à la lecture de la description qui va suivre donnée à titre non limitatif et grâce aux figures annexées parmi lesquelles :
- la figure 1 illustre une interface comprenant un film de polymère et des nanotubes alignés de carbone à la surface d'un substrat selon l'art connu ;
- la figure 2 illustre l'interaction entre des nanotubes de carbone et un groupement benzocyclobutane ;
- la figure 3 illustre un premier exemple de procédé de synthèse d'un polymère de l'invention : le Poly (4-vinylphenyl-1-(bicyclo [4.2.0]octa-1(6), 2,4-trien-3yloxy) hexanoate ;
- la figure 4 illustre un second exemple de procédé de synthèse d'un polymère de l'invention : le Poly (4-vinylphenyl-1-(bicyclo[4.2.0]octa-1.3.5-trien-3-yl hexylether)) ;
- la figure 5 illustre un troisième exemple de procédé de synthèse d'un polymère de l'invention ;
- la figure 6 illustre un quatrième exemple de procédé de synthèse d'un polymère de l'invention ;
- les figures 7a à 7c illustrent les différentes étapes d'un premier exemple de réalisation d'une interface selon l'invention ;
- les figures 8a à 8e illustrent les différentes étapes d'un second exemple de réalisation d'une interface selon l'invention ;
- la figure 9 illustre les différentes résistances prises en compte dans la détermination de la résistance thermique d'une interface selon l'invention.

Les polymères de la présente invention comportent de manière générale, une fonction benzocyclobutane.

Cette fonction ou groupement benzocyclobutane présente l'intérêt de réagir avec des motifs insaturés, par exemple avec les cycles aromatiques et/ou les défauts de nanomatériau de carbone, par exemple des nanotubes de carbone par une réaction de cycloaddition [4+2] sans générer de composés secondaires.

De manière générale, une cycloaddition est une réaction chimique de cyclisation au cours de laquelle deux molécules (ou parties d'une même molécule) insaturées ou plus se combinent pour former un adduit cyclique dans lequel il y a une réduction de la multiplicité de liaison. Les cycloadditions sont habituellement caractérisées par le nombre d'électrons impliqués par chacun des réactifs, indiqués entre crochets. Ainsi, la réaction de Diels-Alder est une cyclo-addition [4 + 2].

La description qui suit mentionne des nanotubes de carbone, mais peut être étendue à tout autre type de nanomatériau présentant des motifs insaturés capables de réagir par cycloaddition avec le benzocyclobutane et pouvant par exemple comprendre des éléments C et/ou B et/ou N, pouvant être de type nanotubes de carbone, nanotubes de BN, ou des nanotubes de carbone dopés N ou encore des feuillets de graphène pouvant être dopés N, présentant des motifs insaturés capables de réagir par cycloaddition avec le benzocyclobutane.

Les nanotubes de carbone peuvent interagir avec la fonction benzocyclobutane selon le schéma suivant illustré en figure 2.

Un échauffement de la fonction benzocyclobutane, typiquement à une température supérieure ou égale à 180°C, avantageusement de 250°C, permet d'ouvrir la fonction pour la faire interagir avec une chaîne carbonée, typiquement un nanotube de carbone.

Des analyses en simulation montrent que les résistances thermiques de contact avec les VACNTs peuvent être réduites par rapport à celles obtenues avec des fonctions azotures.

### Premier exemple de polymère selon l'invention :

Le Poly (4-vinylphenyl-1-(bicyclo[4.2.0]octa-1(6),2,4-trien-3yloxy) hexanoate : PVPO-BCB : 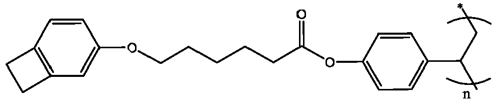 avec n ≥ 1.

Ce polymère PVPO-BCB est dérivé du poly(4-vinylphénol) (chaîne principale). Les chaînes latérales sont greffées sur la fonction phénol.

Ce polymère possède une température de transition vitreuse proche de celle du polymère décrit dans la demande de brevet WO 2012/126955 A1, afin de conserver les mêmes atouts pour la mise en œuvre des interfaces.

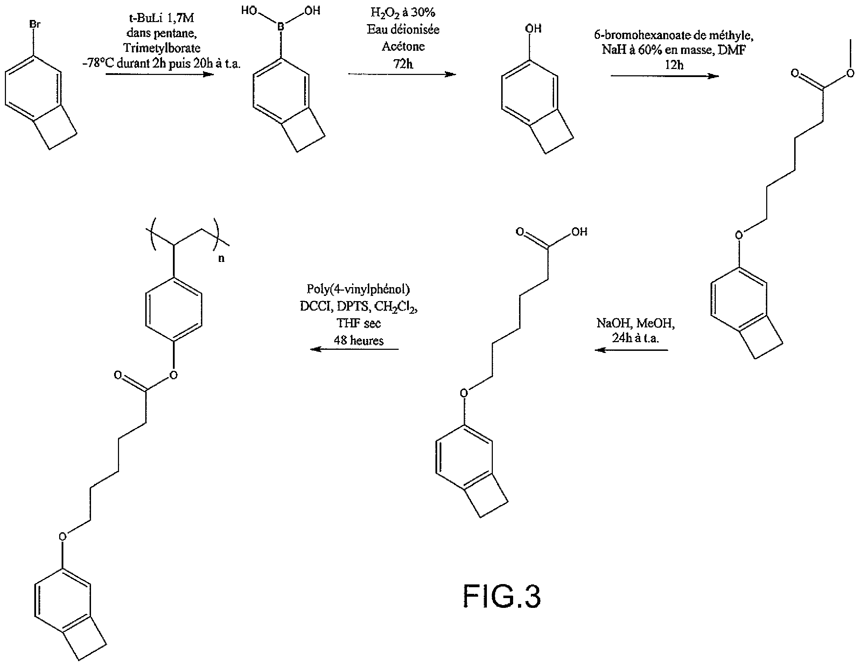

La synthèse du PVPO-BCB est obtenue avec un taux de greffage de 100 %. Le schéma réactionnel est illustré en figure 3.

### Etape 1 :

On fait réagir du bromobenzocyclobutane avec du t-BuLi : *ter-*butyllithium dans du pentane et du trimethylborate pour obtenir l'acide 1.2-dihydrocyclobutabenzene-4-ylboronic.

### Etape 2 :

Le composé obtenu à l'étape 1 est mis en présence de peroxyde d'hydrogène, d'eau déionisée et d'acétone. Le 1.2-dihydrocyclobutabenzene-4-ol est obtenu.

### Etape 3 :

Le composé obtenu à l'étape 2 est mis en présence d'hydrure de sodium (NaH), de diméthyleformamide (DMF) et de 6-bromohexanoate de méthyle. Le 6-(bicyclo[4.2.0]-1(6),2,4-trièn-3-yloxy)hexanoate de méthyle est obtenu.

### Etape 4 :

Le composé obtenu à l'étape 3 est mis en présence de NaOH et de méthanol MeOH. L'acide 6-(bicyclo[4.2.0]-1(6),2,4-trièn-3-yloxy)hexanoïque est obtenu.

### Etape 5 :

On procède alors au greffage des groupements obtenus à l'issue de l'étape 4 sur le poly(4-vinylphénol) en présence de dicyclohexylcarbodiimide (DCCI), de 4-(diméthylamino)pyridinium-4-toluène sulfonate (DPTS), de dichlorométhane (CH₂Cl₂) et de tétrahydrofurane (THF) de manière à obtenir l'exemple de polymère de l'invention le PVPO-BCB.

Ce polymère présente :
- une température de dégradation de 437 °C
- une température de transition vitreuse de 3°C

### Second exemple de polymère selon l'invention :

Le Poly (4-vinylphenyl-1-(bicyclo[4.2.0]octa-1,3,5-trien-3-yl hexylether)) 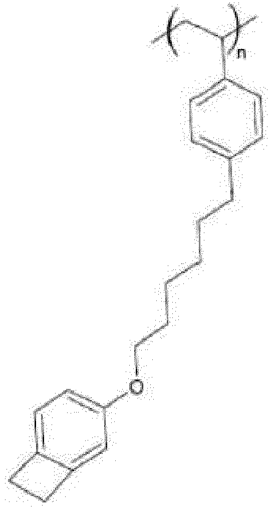 avec n ≥ 1.

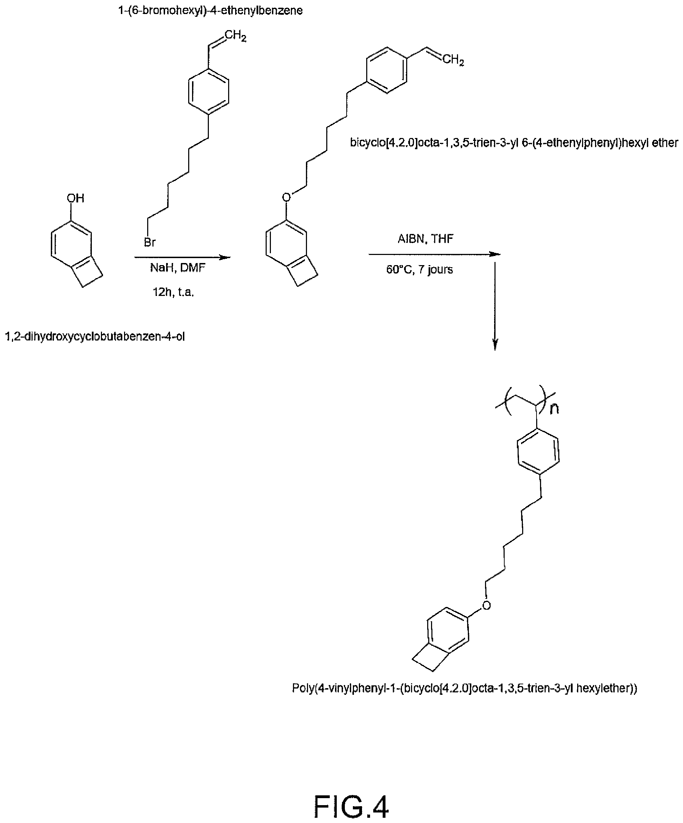

Le schéma réactionnel de synthèse du polymère est illustré en figure 4 :

### Etape 1 :

Le dihydrocyclobutabenzene-4-ol est mis en présence d'hydrure de sodium (NaH), de diméthyleformamide (DMF) et du 1-(6-bromohexyl)-4-ethenylbenzene. Le 6-(bicyclo[4.2.0]-1(6),2,4-trièn-3-yloxy)hexanoate de méthyle est obtenu.

### Etape 2 :

Le composé obtenu à l'étape 1 est mis en réaction avec de l'azobisisobutyronitrile (AIBN) et du tétrahydrofurane (THF) afin d'obtenir ledit polymère.

### Troisième exemple de polymère selon l'invention :

Le polymère répondant à la formule chimique ci-après : 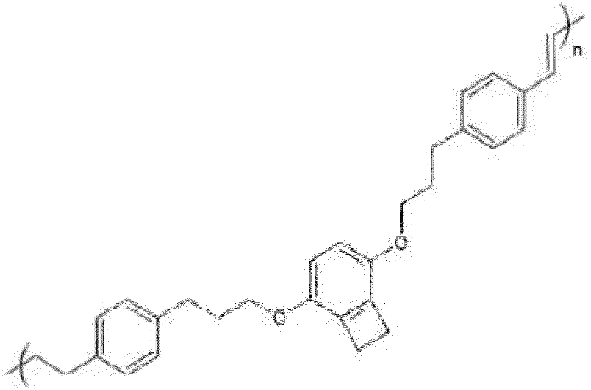 avec n ≥ 1.

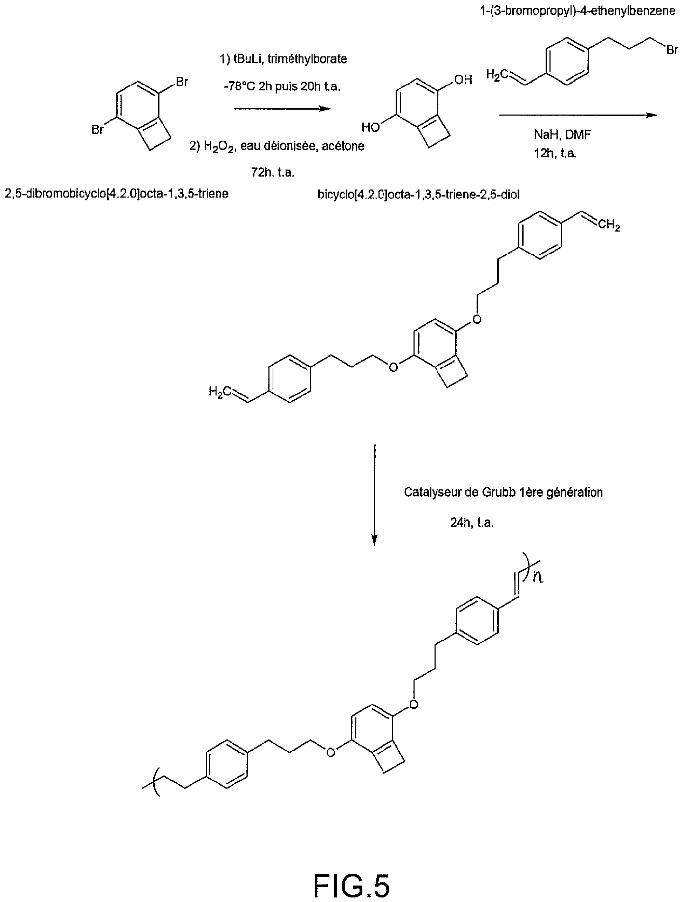

Le schéma réactionnel de synthèse du polymère est illustré en figure 5.

### Etape 1 :

Le 2.5-dibromobicyclo[4.2.0]octa-1,3,5-triène est mis en réaction avec du_*ter*-butyllithium dans du pentane et du trimethylborate pour obtenir l'acide 1.2-dihydrocyclobutabenzene-4-ylboronic.

Puis dans un second temps, avec du peroxyde d'hydrogène, de l'eau déionisée et de l'acétone., le 1.2-dihydrocyclobutabenzene-4-ol est obtenu

### Etape 2 :

Le composé obtenu à l'étape 1 est mis en présence d'hydrure de sodium (NaH), de diméthyleformamide (DMF) et du 1-(3-bromopropyl)-4-ethenylbenzène. Le 2-(4-vinylphenetoxy)-5-(3-(4-vinylphenyl)propoxy) bicyclo[4.2.0]octa-1,3,5-triene est obtenu.

### Etape 3 :

Le composé obtenu à l'étape 2 est mis en présence du catalyseur de Grubb première génération afin d'obtenir ledit polymère.

### Quatrième exemple de polymère selon l'invention

Le polymère répondant à la formule chimique ci-après : 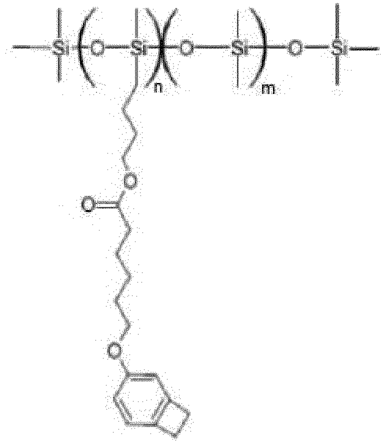 avec n ≥ 1 et avec m ≥ 1.

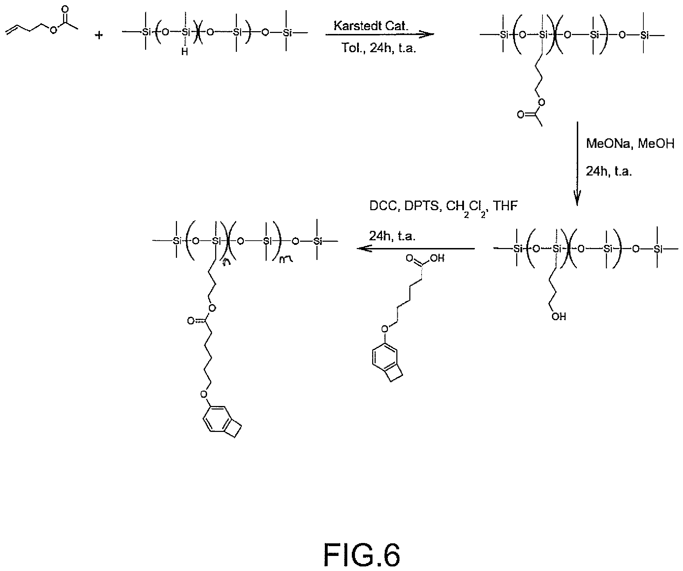

Le schéma réactionnel de synthèse du polymère est illustré en figure 6.

### Etape 1 :

Le polymère servant de chaine principale est mis en présence du catalyseur de Karstedt, de toluène et d'éthanoate de butène.

### Etape 2 :

Le composé obtenu à l'étape 1, est mis en réaction avec du méthanol et du méthanolate de sodium.

### Etape 3 :

Le composé obtenu à l'étape 2, est mis en présence de dicyclohexylcarbodiimide (DCCI), de 4-(diméthylamino)pyridinium-4-toluène sulfonate (DPTS), de dichlorométhane (CH₂Cl₂) et de tétrahydrofurane (THF). Le polymère est ainsi obtenu.

### Premier exemple de réalisation d'une interface thermique mettant en œuvre une seule couche de polymère de l'invention :

### Etape 1 :

On procède à la croissance de nanotubes de carbone VACNTs 200 à la surface d'un substrat de croissance 100 pouvant typiquement être en silicium.

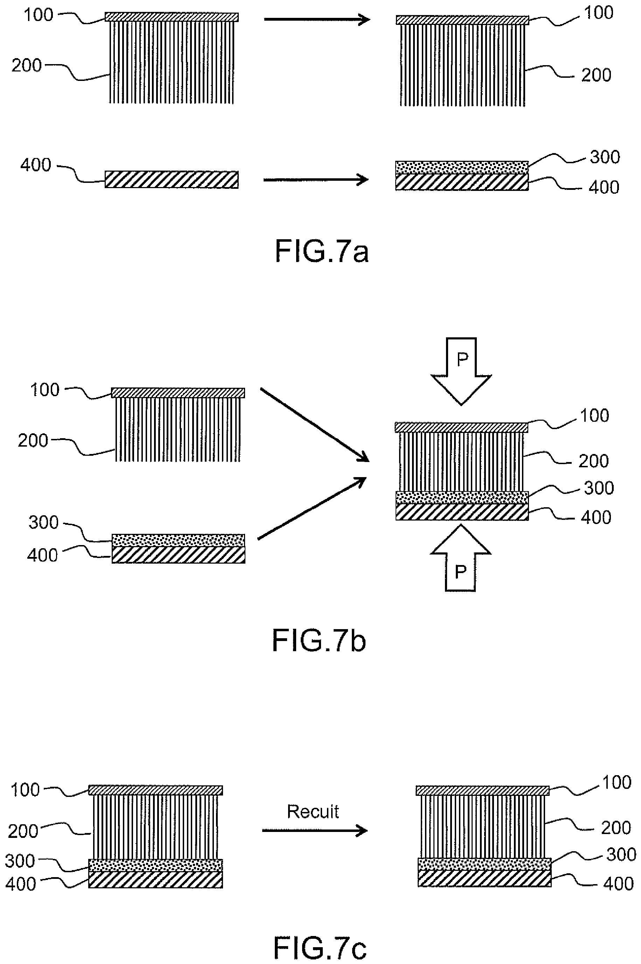

Typiquement les nanotubes peuvent présenter une hauteur d'environ 10 µm. En parallèle, on réalise une couche 300 de polymère de l'invention à la surface d'un second substrat 400 pouvant typiquement être un substrat de cuivre. Typiquement l'épaisseur de la couche de polymère peut être de quelques centaines de nanomètres, avantageusement de l'ordre de 300 nm. Cette étape est illustrée en figure 7a.

### Etape 2 :

On assemble les deux substrats 100 et 400 recouverts respectivement de nanotubes de carbone 200 et de polymère 300 et l'on applique une pression P à l'ensemble. Typiquement la pression P peut être de l'ordre quelques centaines de kPa pendant un temps court (de l'ordre de quelques minutes). Cette étape est illustrée en figure 7b.

### Etape 3 :

On procède à une opération de recuit à une température de l'ordre de 250°C en présence ou non d'une pression appliquée. Cette étape est illustrée en figure 7c qui illustre l'interface réalisée et comprenant les éléments 100/200/300/400.

### Second exemple de réalisation d'une interface thermique mettant en œuvre deux films de polymère de l'invention :

### Etape 1 :

On procède à la croissance de nanotubes de carbone VACNTs 200 à la surface d'un substrat de croissance 100 pouvant typiquement être en silicium.

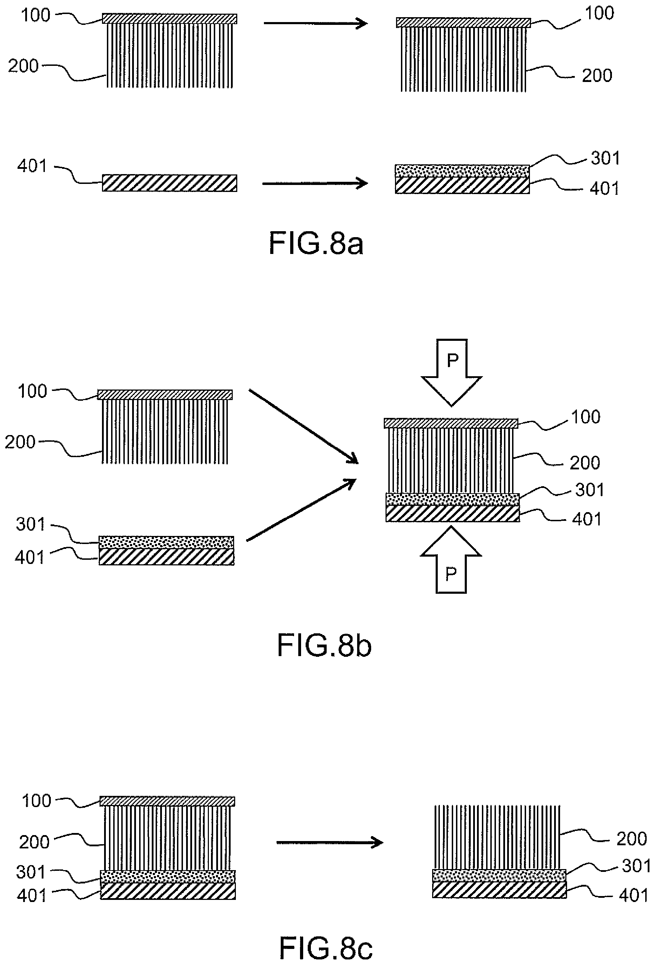

En parallèle, on réalise une première couche 301 de polymère de l'invention à la surface d'un second substrat 401 pouvant typiquement être un substrat de cuivre. Cette étape est illustrée en figure 8a.

### Etape 2 :

On assemble les deux substrats 100 et 401 recouverts respectivement de nanotubes de carbone et de polymère et l'on applique une pression à l'ensemble. Typiquement la pression peut être de l'ordre quelques centaines de kPa pendant un temps court (de l'ordre de quelques minutes). Cette étape est illustrée en figure 8b.

### Etape 3 :

On vient retirer le substrat de croissance 100 pour laisser à nu, les nanotubes de carbone VACNTs 200, en contact avec la couche de polymère 301 à la surface du substrat 401. Cette étape est illustrée en figure 8c.

### Etape 4 :

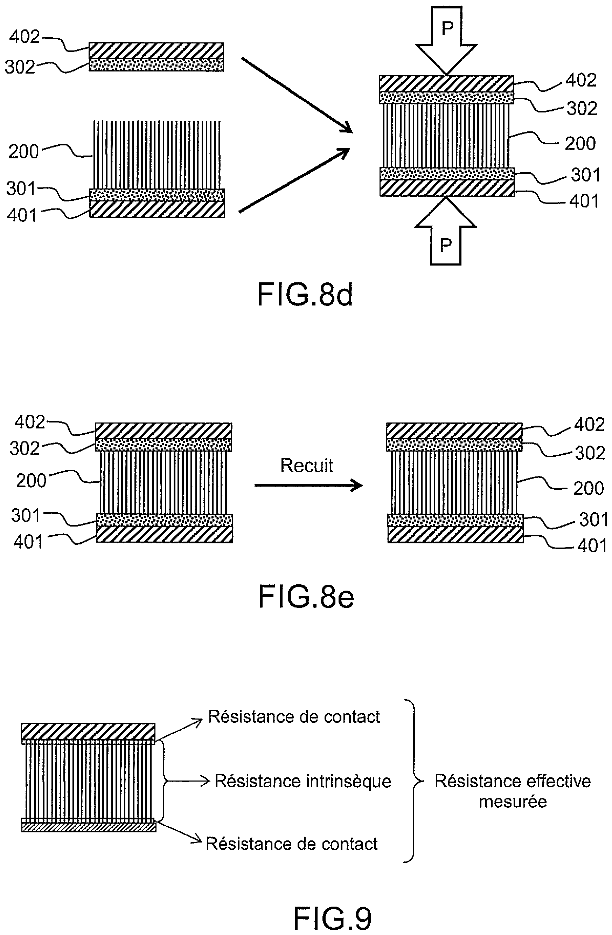

On assemble un substrat 402 à la surface duquel est déposée une seconde couche 302 de polymère avec l'ensemble 401/301/200 préconstitué comme illustré en figure 8d.

On applique une pression à l'ensemble, typiquement la pression peut être de l'ordre quelques centaines de kPa pendant un temps court (de l'ordre de quelques minutes).

### Etape 5 :

On procède à une opération de recuit à une température de l'ordre de 250°C en présence ou non d'une pression appliquée. Cette étape est illustrée en figure 8e et montre l'interface ainsi réalisée et comprenant entre les substrats 401 et 402, deux couches de polymère 301 et 302 et une couche de nanotubes 200.

Il est à noter qu'il est possible de procéder à une étape de recuit finale (une fois le deuxième report effectué) ou qu'il est possible de procéder à deux étapes de recuit, la première ayant lieu après la première mise en pression et la seconde, après la seconde mise en pression des VACNTs avec le troisième substrat. L'étape de recuit permet de bénéficier de l'avantage des fonctions réactives portées par le polymère.

### Mesures réalisées sur des interfaces de l'invention :

Les propriétés thermiques sont mesurées par l'impédancemètre thermique.

Les interfaces thermiques présentent une résistance thermique de 1,4 mm²K/W. La résistance thermique est divisée par un facteur 2 par rapport à celle obtenue avec le polymère PVPH-N₃ décrit dans la demande de brevet WO 2012/126955 A1 précédemment citée, ce qui permet de rester compétitif dans le domaine des matériaux d'interface thermique.

Des études d'observations des interfaces ont été menées par microscope électronique à balayage et ont montré l'absence de formation de zones interstitielles remplies de gaz. De même, l'épaisseur du polymère reste inchangée et permet de conserver une épaisseur de 300 nm (qui a été définie comme étant l'épaisseur optimale pour avoir la résistance thermique la plus faible).

Une étude du taux de greffage sur les nanotubes de carbone a été réalisée sur les fonctions BCB et Azotures. Les résultats montrent un greffage supérieur de 33% pour la fonction BCB.

Par ailleurs, le polymère est résistant à hautes températures (380-400°C), ce qui est nécessaire pour résister aux étapes de fabrication des composants électroniques.

En conclusion, l'utilisation du nouveau polymère fonctionnel à base de fonction benzocyclobutane selon l'invention permet une nette diminution (facteur 2) de la résistance thermique des interfaces réalisées à 230-250°C et avec des nanotubes d'une hauteur de 10 µm.

Les résistances thermiques obtenues sont de 1,4 mm²K/W, correspondant à une valeur très basse par rapport à celles rapportées par la littérature.

L'emploi de ce type de polymère permet ainsi la réalisation d'interfaces compatibles avec les procédés de mise en œuvre des composants électroniques et des opérations de packaging utilisés dans le milieu industriel.

## Revendications

1. Polymère apte à créer des liaisons avec un nanomatériau présentant des motifs insaturés capables de réagir par cycloaddition avec le benzocyclobutane **caractérisé en ce que** le polymère étant un homopolymère ou un copolymère, il comprend au moins un groupement benzocyclobutane en chaîne principale ou en chaîne pendante et répond à l'une des formules chimiques suivantes : 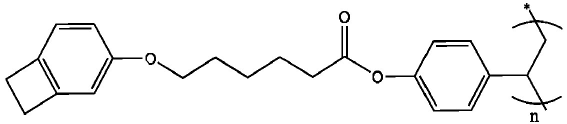 avec n ≥ 1
ou 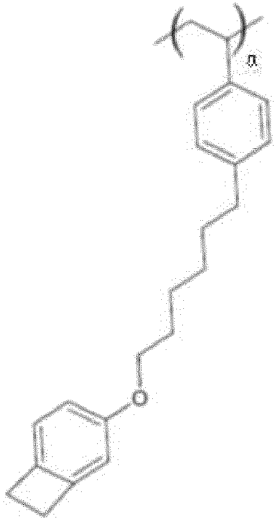 avec n ≥ 1
ou 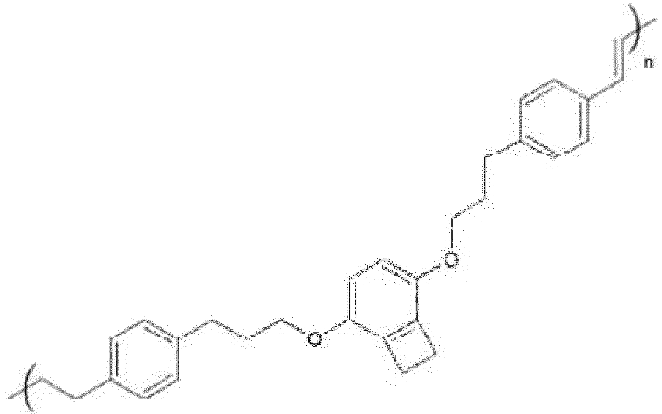 avec n ≥ 1
ou 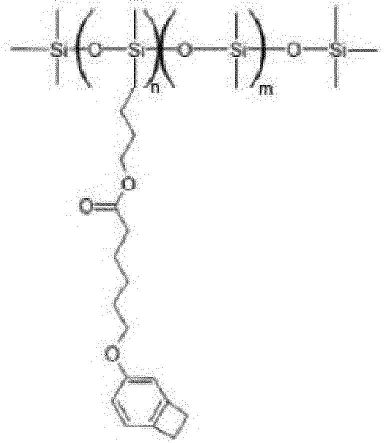 avec n ≥ 1 et avec m ≥ 1

2. Procédé de synthèse d'un polymère répondant à l'une des formules chimiques suivantes : 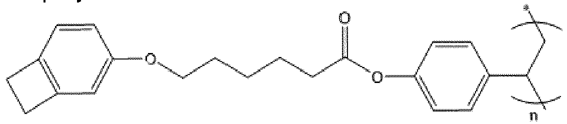 avec n ≥ 1
ou 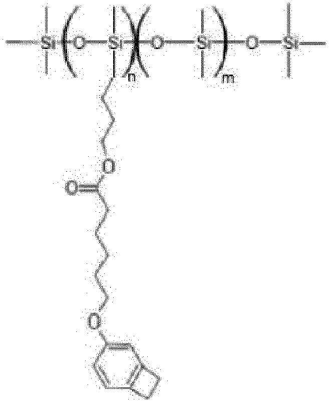 avec n ≥ 1 et m ≥ 1
et comprenant les étapes suivantes :
- le greffage d'un composé comprenant un groupement benzocyclobutane avec un groupement espaceur pour obtenir un composé intermédiaire ;
- le greffage dudit composé intermédiaire sur un polymère hôte.

3. Procédé de synthèse selon la revendication 2, dans lequel le polymère répond à la formule chimique suivante : 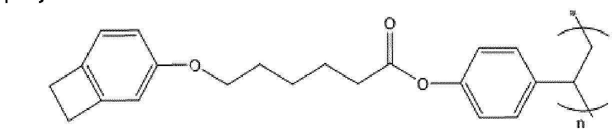 avec n ≥ 1
et dans lequel le polymère hôte est du poly(4-vinylphénol).

4. Interface thermique comprenant au moins une couche de nanomatériau présentant des motifs insaturés capables de réagir par cycloaddition avec le benzocyclobutane (200) **caractérisée en ce qu'**elle comporte en outre au moins une couche de matériau polymère (300) selon la revendication 1, en contact avec ladite couche de nanomatériau présentant des motifs insaturés capables de réagir par cycloaddition avec le benzocyclobutane

5. Interface thermique selon la revendication 4, dans laquelle le nanomatériau comprend des éléments C et/ou B et/ou N, pouvant être de type nanotubes de carbone, nanotubes de BN, ou nanotubes de carbone dopés N ou encore des feuillets de graphène pouvant être dopés N, des nanofibres de carbone.

6. Interface thermique selon l'une des revendications 4 ou 5, dans laquelle la couche de nanomatériau est une couche de nanotubes alignés, pouvant être des nanotubes de carbone.

7. Interface thermique selon l'une des revendications 4 à 6, comprenant une couche de nanomatériau comprise entre une première couche de polymère (301) et une seconde couche de polymère (302).

8. Dispositif électronique comprenant une interface thermique selon l'une des revendications 4 à 7, insérée entre un premier substrat et un second substrat, le premier substrat étant un substrat dissipant thermiquement et le second substrat étant un substrat dissipateur thermiquement.

9. Procédé de fabrication d'une interface thermique selon l'une des revendications 4 à 7, **caractérisé en ce qu'**il comprend les étapes suivantes :
- la réalisation d'une couche de nanomatériau présentant des motifs insaturés capables de réagir par cycloaddition avec le benzocyclobutane (200) à la surface d'un premier support de croissance (100) ;
- la réalisation d'une couche de polymère (300) à la surface d'un second support (400) ;
- l'assemblage des deux supports.

10. Procédé de fabrication d'une interface thermique selon l'une des revendications 4 à 7, comprenant :
- la réalisation d'une couche de nanomatériau présentant des motifs insaturés capables de réagir par cycloaddition avec le benzocyclobutane (200) à la surface d'un premier support de croissance (100) ;
- la réalisation d'une couche de polymère (300) à la surface d'un second support (400) ;
- l'assemblage des deux supports ;
- une opération de retrait dudit premier support (100) après l'assemblage de manière à le désolidariser de la couche de nanomatériau (200) ;
- le report d'un troisième support (402) sur lequel est déposé une seconde couche de polymère (302) à la surface de la couche de nanomatériau .

11. Procédé de fabrication d'une interface thermique selon l'une des revendications 9 à 10, comprenant au moins une étape de recuit d'au moins un assemblage préconstitué.

## Patentansprüche

1. Polymer, das Bindungen mit einem Nanomaterial schaffen kann, das ungesättigte Einheiten aufweist, die durch Cycloaddition mit Benzocyclobutan reagieren können, **dadurch gekennzeichnet, dass** da das Polymer ein Homopolymer oder ein Copolymer ist, es mindestens eine Benzocyclobutangruppe in einer Hauptkette oder Seitenkette umfasst und einer der folgenden chemischen Formeln entspricht: 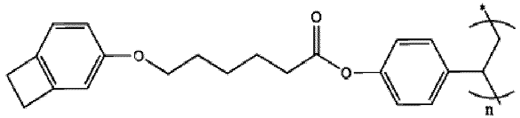 wobei n ≥ 1 ist,
oder 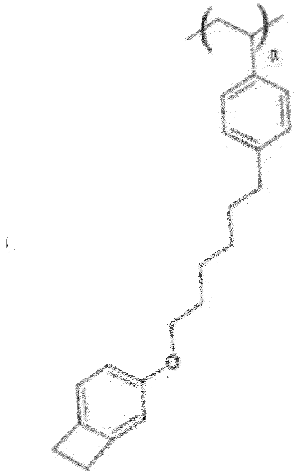 wobei n ≥ 1 ist,
oder 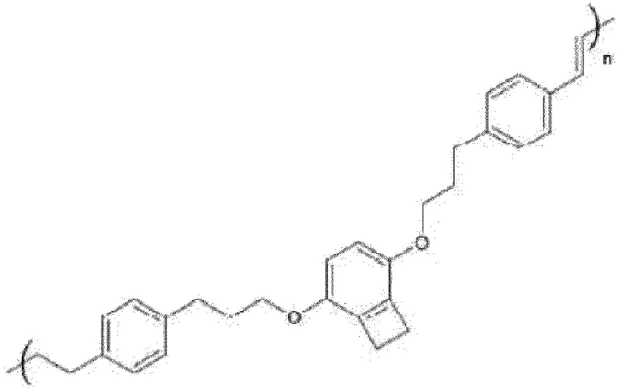 wobei n ≥ 1 ist,
oder 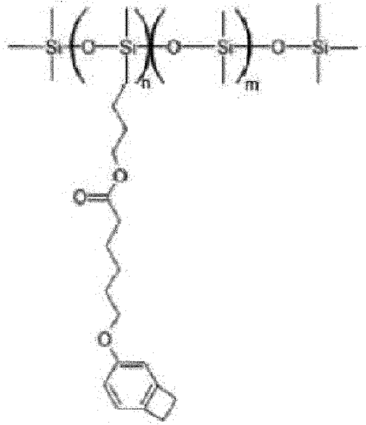 wobei n ≥ 1 ist und wobei m ≥ 1 ist.

2. Verfahren zur Synthese eines Polymers entsprechend einer der folgenden chemischen Formeln: 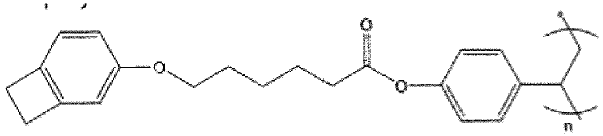 wobei n ≥ 1 ist,
oder 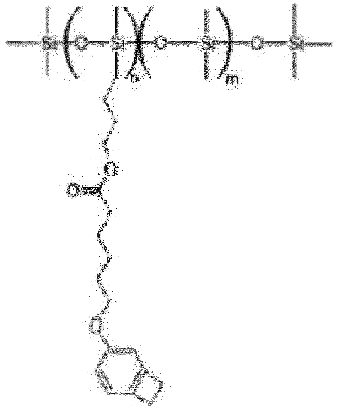 wobei n ≥ 1 ist und wobei m ≥ 1 ist,
und das die folgenden Schritte beinhaltet:
- Pfropfen einer Verbindung, die eine Benzocyclobutangruppe enthält, mit einer Spacergruppe, um eine Zwischenverbindung zu erhalten;
- Pfropfen dieser Zwischenverbindung auf ein Wirtspolymer.

3. Syntheseverfahren nach Anspruch 2, wobei das Polymer der folgenden chemischen Formel entspricht: 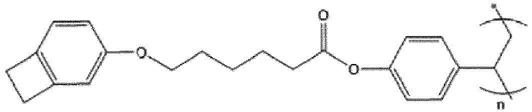 wobei n ≥ 1 ist,
und wobei das Wirtspolymer Poly(4-vinylphenol) ist.

4. Thermische Schnittstelle mit mindestens einer Schicht aus Nanomaterial mit ungesättigten Einheiten, die durch Cycloaddition mit Benzocyclobutan (200) reagieren können, **dadurch gekennzeichnet, dass** sie ferner mindestens eine Schicht aus Polymermaterial (300) nach Anspruch 1 in Kontakt mit der Schicht aus Nanomaterial mit ungesättigten Einheiten umfasst, die durch Cycloaddition mit Benzocyclobutan reagieren können.

5. Thermische Schnittstelle nach Anspruch 4, wobei das Nanomaterial C- und/oder B- und/oder N-Elemente umfasst, die vom Typ Kohlenstoff-Nanoröhren, BN-Nanoröhren, oder N-dotierte Kohlenstoff-Nanoröhren oder Graphenblätter, die N-dotiert sein können, Kohlenstoff-Nanofasern, sein können.

6. Thermische Schnittstelle nach Anspruch 4 oder 5, wobei die Nanomaterialschicht eine Schicht aus ausgerichteten Nanoröhren ist, die Kohlenstoff-Nanoröhren sein können.

7. Thermische Schnittstelle nach einem der Ansprüche 4 bis 6, die eine Nanomaterialschicht zwischen einer ersten Polymerschicht (301) und einer zweiten Polymerschicht (302) umfasst.

8. Elektronische Vorrichtung mit einer thermischen Schnittstelle nach einem der Ansprüche 4 bis 7, die zwischen einem ersten Substrat und einem zweiten Substrat eingefügt ist, wobei das erste Substrat ein wärmeableitendes Substrat und das zweite Substrat ein wärmeableitendes Substrat ist.

9. Verfahren zur Herstellung einer thermischen Schnittstelle nach einem der Ansprüche 4 bis 7, **dadurch gekennzeichnet, dass** es die folgenden Schritte beinhaltet:
- Bereitstellen einer Schicht aus Nanomaterial mit ungesättigten Einheiten, die durch Cycloaddition mit Benzocyclobutan (200) reagieren können, auf der Oberfläche eines ersten Wachstumsmediums (100);
- Bereitstellen einer Polymerschicht (300) auf der Oberfläche eines zweiten Trägers (400);
- Zusammenbauen der beiden Träger.

10. Verfahren zur Herstellung einer thermischen Schnittstelle nach einem der Ansprüche 4 bis 7, das Folgendes beinhaltet:
- Bereitstellen einer Schicht aus Nanomaterial mit ungesättigten Einheiten, die durch Cycloaddition mit Benzocyclobutan (200) reagieren können, auf der Oberfläche eines ersten Wachstumsträgers (100);
- Bereitstellen einer Polymerschicht (300) auf der Oberfläche eines zweiten Trägers (400);
- Zusammenbauen der beiden Träger;
- einen Schritt des Entfernens des ersten Trägers (100) nach dem Zusammenbauen, um ihn von der Nanomaterialschicht (200) zu trennen;
- Verschieben eines dritten Trägers (402), auf dem eine zweite Polymerschicht (302) abgelagert ist, auf der Oberfläche der Nanomaterialschicht.

11. Verfahren zur Herstellung einer thermischen Schnittstelle nach einem der Ansprüche 9 bis 10, das mindestens einen Schritt des Glühens mindestens einer vormontierten Baugruppe beinhaltet.

## Claims

1. Polymer which is capable of creating connections with a nanomaterial which has unsaturated units which are capable of reacting with benzocyclobutane by means of cycloaddition, **characterised in that**, the polymer being a homopolymer or a copolymer, it comprises at least one benzocyclobutane group in a main chain or in a pendant chain and corresponds to one of the following chemical formulae: 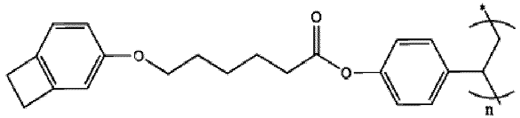 with n ≥ 1
or 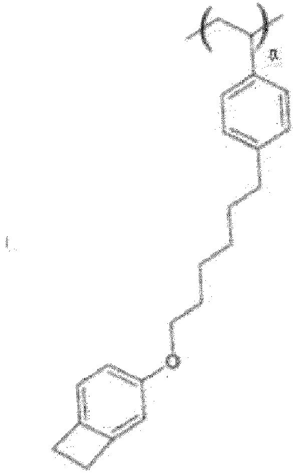 with n ≥ 1
or 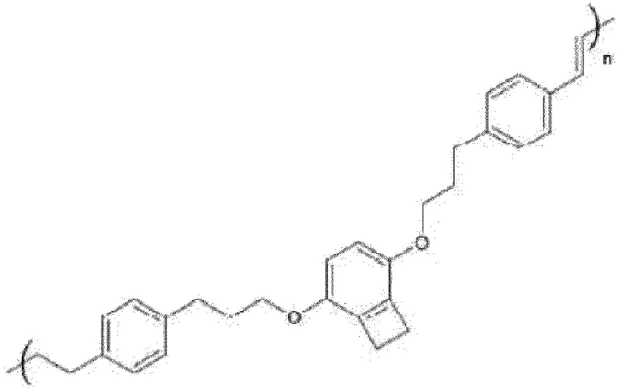 with n ≥ 1
or 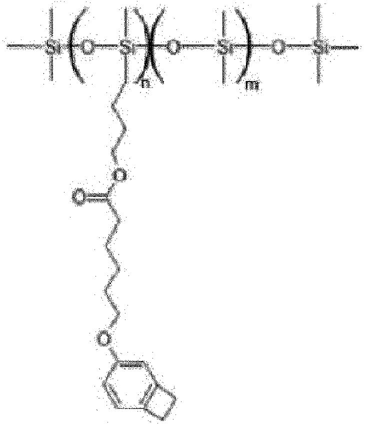 with n ≥ 1 and with m ≥ 1

2. A synthetizing method for a polymer corresponding to one of the following chemical formulae: 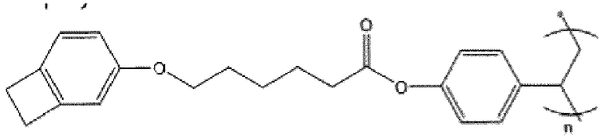 with n ≥ 1
or 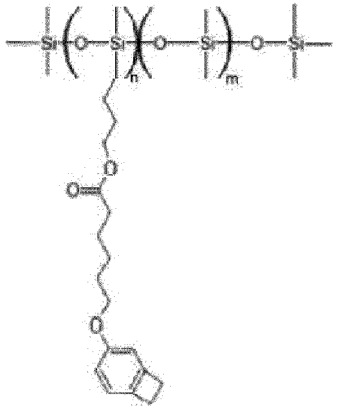 with n ≥ 1 and m ≥ 1
and comprising the following steps:
- grafting a compound comprising a benzocyclobutane group with a spacer group in order to obtain an intermediate compound;
- grafting the said intermediate compound to a host polymer.

3. The synthetizing method according to claim 2, wherein the polymer corresponds to the following chemical formula: 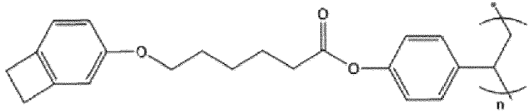 with n ≥ 1
and wherein the host polymer is poly(4-vinylphenol).

4. Thermal interface comprising at least one layer of nanomaterial having unsaturated units which are capable of reacting with benzocyclobutane (200) by means of cycloaddition, **characterised in that** it further comprises at least one layer of polymer material (300) according to claim 1, in contact with the layer of nanomaterial which has unsaturated units which are capable of reacting with benzocyclobutane by means of cycloaddition.

5. Thermal interface according to claim 4, wherein the nanomaterial comprises C and/or B and/or N elements, which may be of the type carbon nanotubes, BN nanotubes, or N-doped carbon nanotubes or sheets of graphene which may be N-doped, carbon nanofibers.

6. Thermal interface according to either claim 4 or claim 5, wherein the layer of nanomaterial is a layer of aligned nanotubes which may be carbon nanotubes.

7. Thermal interface according to any one of claims 4 to 6, comprising a layer of nanomaterial contained between a first layer of polymer (301) and a second layer of polymer (302).

8. Electronic device comprising a thermal interface according to any one of claims 4 to 7, which is inserted between a first substrate and a second substrate, the first substrate being a thermally dissipating substrate and the second substrate being a thermally dissipating substrate.

9. Method for producing a thermal interface according to any one of claims 4 to 7, **characterised in that** it comprises the following steps:
- producing a layer of nanomaterial which has unsaturated units which are capable of reacting with benzocyclobutane (200) by means of cycloaddition on the surface of a first growth support (100);
- producing a layer of polymer (300) on the surface of a second support (400);
- assembling the two supports.

10. Method for producing a thermal interface according to any one of claims 4 to 7, comprising:
- the production of a layer of nanomaterial which has unsaturated units which are capable of reacting by means of cycloaddition with benzocyclobutane (200) on the surface of a first growth support (100);
- producing a layer of polymer (300) on the surface of a second support (400);
- assembling the two supports;
- an operation for withdrawing the said first support (100) after assembly in order to disengage it from the layer of nanomaterial (200);
- the transfer of a third support (402), on which a second layer (302) of polymer is deposited, to the surface of the layer of nanomaterial.

11. Method for producing a thermal interface according to either claim 9 or 10, comprising at least one step of annealing at least one pre-constituted assembly.
